# EUROPÄISCHE PATENTSCHRIFT

(11) **EP 3 089 077 B1**
(45) Veröffentlichungstag und Bekanntmachung des Hinweises auf die Patenterteilung: **12.09.2018**
(21) Anmeldenummer: 16166301.8
(22) Anmeldetag: 21.04.2016
(51) Int. Cl.: G06K 19/07, G06K 19/077, G01R 31/265

(54) **VERFAHREN ZUR PRÜFUNG EINER INTEGRIERTEN SCHALTUNG, DOKUMENT, PRÜFSYSTEM UND PERSONALISIERUNGSVORRICHTUNG**
METHOD FOR TESTING AN INTEGRATED CIRCUIT, DOCUMENT, INSPECTION SYSTEM AND PERSONALIZATION DEVICE
PROCEDE DE CONTROLE D'UN CIRCUIT INTEGRE, DOCUMENT, SYSTEME DE CONTROLE ET DISPOSITIF DE PERSONNALISATION

(30) Priorität: 28.04.2015 DE 102015207745
(43) Veröffentlichungstag der Anmeldung: 02.11.2016
(73) Patentinhaber: Bundesdruckerei GmbH, 10969 Berlin (DE)
(72) Erfinder: PETERS, Florian, 12103 Berlin (DE); SCHOLZE, Steffen, 13469 Berlin (DE)
(74) Vertreter: Richardt Patentanwälte PartG mbB

(56) Entgegenhaltungen:
- EP-A2- 2 234 030
- DE-A1-102012 022 735

## Beschreibung

Die Erfindung betrifft ein Verfahren zur Prüfung einer integrierten Schaltung mit einer kontaktlosen HF-Schnittstelle sowie ein Dokument, insbesondere ein Wert- oder Sicherheitsdokument, wie zum Beispiel ein Ausweisdokument, mit einem Dokumentenkörper, der eine solche integrierte
Schaltung beinhaltet.

Dokumente mit einem RFID-Transponder sind beispielsweise in der Form von Chipkarten oder Passbüchern an sich aus dem Stand der Technik bekannt, wie zum Beispiel aus der WO 2011/030947 A1. Chipkartenkommunikationsprotokolle und - verfahren für die kontaktlose Kommunikation mit dem Chip eines solchen Dokuments sind zum Beispiel in der Norm ISO 14443 festgelegt.

Die europäische Offenlegungsschrift EP 2 234 030 A2 betrifft ein Verfahren zur Personalisierung einer Chipkarte. Dieses erlaubt es, eine Chipkarte von einem Erstbenutzungsstatus in einen Benutztstatus zu überführen. Dafür sind in der Chipkarte ein Chiffrat sowie eine Transport-Pin gespeichert. An die Chipkarte kann ein Schlüssel übermittelt werden, der es erlaubt, das Chiffrat zu entschlüsseln. Stimmt das entschlüsselte Chiffrat mit dem Schlüssel überein, so wird die Chipkarte in den Benutztstatus überführt.

Die deutsche Offenlegungsschrift DE 10 2012 022 735 A1 betrifft ein Verfahren zum Betreiben eines Kommunikationssystems. Dabei wird mittels einer Überprüfung einer Signallaufzeit festgestellt, ob durch ein Lesegerät tatsächlich mit einem als einem Endgerät vorgesehenen Transponder kommuniziert wird, oder ob sich ein Angreifer zwischen das Endgerät und das Lesegerät geschaltet hat.

Der Erfindung liegt die Aufgabe zugrunde, ein verbessertes Verfahren zur Prüfung einer integrierten Schaltung mit einer kontaktlosen HF-Schnittstelle zu schaffen sowie ein Dokument, das eine solche integrierte Schaltung beinhaltet, ein Prüfsystem und eine Personalisierungsvorrichtung für ein solches Dokument.

Die der Erfindung zugrunde liegenden Aufgaben werden jeweils mit den Merkmalen der unabhängigen Patentansprüche gelöst. Ausführungsformen der Erfindung sind in den abhängigen Patentansprüchen angegeben.

Unter einer "kontaktlosen HF-Schnittstelle" wird hier insbesondere eine Kommunikationsschnittstelle verstanden, wobei die Kommunikation über eine hochfrequente Trägerwelle, beispielsweise im Megahertzbereich, insbesondere nach einem RFID- oder NFC-Verfahren im Nahfeld erfolgt. Vorzugsweise erfolgt die Einkopplung der für den Betrieb der integrierten Schaltung erforderlichen Energie ebenfalls über die Trägerwelle, sodass eine separate Energieversorgung der integrierten Schaltung und der daran gegebenenfalls angeschlossenen Verbraucher nicht erforderlich ist.

Unter einer "integrierten Schaltung" wird hier insbesondere eine elektronische Halbleiterschaltung, insbesondere ein Chip, oder eine aufgedruckte elektronische Schaltung, wie zum Beispiel eine polymerelektronische Schaltung, oder eine Kombination daraus verstanden.

Unter einem "Chipkartenkommando" wird hier insbesondere eine sogenannte Kommando-APDU (Application Protocol Data Unit) verstanden, auf welche eine Antwort APDU nach einem Request-Response-Kommunikationsprotokoll erzeugt wird.

Unter einem "Terminal" wird hier insbesondere ein elektronisches Gerät verstanden, das dazu konfiguriert ist, Chipkartenkommandos zu senden und Antworten auf Chipkartenkommandos zu empfangen, wobei das Terminal eine zu der integrierten Schaltung kompatible kontaktlose HF-Schnittstelle aufweist.

Unter einem "Dokument" werden hier insbesondere papierbasierte und/oder kunststoffbasierte Dokumente verstanden, wie zum Beispiel elektronische Ausweisdokumente, insbesondere Reisepässe, Personalausweise, Visa sowie Führerscheine, Fahrzeugscheine, Fahrzeugbriefe, Firmenausweise, Gesundheitskarten oder andere ID-Dokumente sowie auch Chipkarten, Zahlungsmittel, insbesondere Banknoten, Bankkarten und Kreditkarten, Frachtbriefe oder sonstige Berechtigungsnachweise, in die ein nicht-flüchtiger elektronischer Datenspeicher zur Speicherung zumindest eines Attributs integriert ist.

Nach Ausführungsformen der Erfindung erfolgt die Prüfung der integrierten Schaltung, insbesondere zur Bewertung einer vordefinierten Qualitätsanforderungen der Schaltung, mit der kontaktlosen HF-Schnittstelle, indem ein Terminal ein vordefiniertes Prüfkommando an die kontaktlose HF-Schnittstelle sendet. Nur unter der Voraussetzung, dass sich die integrierten Schaltung in ihrem ersten unpersonalisierten Zustand befindet, führt die integrierte Schaltung das Prüfkommando aus und sendet anschließend die Prüfantwort an den Terminal zurück.

Das Terminal bestimmt/erfasst die Zeitdauer, die zwischen dem Senden des Prüfkommandos und dem Empfangen der Prüfantwort vergangen ist. Das Terminal prüft anschließend, ob diese Zeitdauer innerhalb eines vorgegebenen Toleranzbereichs liegt. Das Terminal signalisiert dann das Ergebnis der Prüfung.

Nach Ausführungsformen der Erfindung ist die integrierte Schaltung dazu ausgebildet, ein Wartezeit-Verlängerungssignal über die kontaktlose HF-Schnittstelle an den Terminal zu senden, um eine Verlängerung der Wartezeit des Terminals auf die Antwort der integrierten Schaltung auf ein Chipkartenkommandos des Terminals anzufordern. Hierbei kann es sich um ein Waiting Time Extension (WTX)-Signal handeln, welches auch als Frame Waiting Time Extension-Signal bezeichnet wird, insbesondere wie in ISO/IEC 14443 spezifiziert. Durch Senden eines Waiting Time Extension-Signals soll die Wartezeit des Terminals nach dem Senden eines Chipkartenkommandos auf die entsprechende Antwort der integrierten Schaltung verlängert werden, was insbesondere dann der Fall ist, wenn die integrierte Schaltung aufgrund einer relativ geringen Leistungseinkopplung mit einer niedrigen Taktrate betrieben werden muss. Das Terminal kann so ausgebildet sein, dass er das Signal zur Signalisierung des Bestehens der Prüfung nur unter der zusätzlichen Voraussetzung erzeugt, dass das Wartezeit-Verlängerungssignal von dem Terminal nach Senden des Prüfkommandos nicht empfangen wird oder dass das Wartezeit-Verlängerungssignal nur eine maximale Anzahl von Wiederholungen durch den Terminal empfangen wird, wenn eine einfache oder mehrfache Verlängerung der Wartezeit tolerierbar ist.

Nach Ausführungsformen der Erfindung ist die integrierte Schaltung dazu ausgebildet, ein Feldstärke-Erhöhungssignal zu erzeugen und über die HF-Schnittstelle an den Terminal zu senden, insbesondere dann, wenn die über die Trägerwelle eingekoppelte Leistung relativ gering ist. Wenn die integrierte Schaltung ein solches Feldstärke-Erhöhungssignal zur Anforderung einer Erhöhung der Feldstärke, mit der die Trägerwelle von dem Terminal abgestrahlt wird, anzufordern, so deutet dies darauf hin, dass die Güte und/oder die Resonanzfrequenz des Schwingkreises nicht den Qualitätsanforderungen entsprechen, da die eingekoppelte Leistung bei der vom Terminal vorgegebenen Feldstärke nicht ausreichend ist. Der Terminal kann so ausgebildet sein, dass er das Signal zur Signalisierung des Bestehens der Prüfung nur unter der zusätzlichen Voraussetzung abgibt, dass er nach dem Senden des Prüfkommandos kein Feldstärke-Erhöhungssignal empfängt.

Nach Ausführungsformen der Erfindung beinhaltet die Durchführung der vorbestimmten Sequenz von Operationen aufgrund der Ausführung des Prüfkommandos die Einschaltung von einem oder mehreren elektrischen Verbrauchern der integrierten Schaltung, wie zum Beispiel einen nicht-flüchtigen Speicher, einen Hardware-Zufallszahlengenerator, einen Hardware-Coprozessor, insbesondere einen Hardware-Coprozessor für symmetrische und/oder asymmetrische kryptografische Verfahren, eine Recheneinheit und/oder eine Memory Management Unit.

Nach Ausführungsformen der Erfindung ist das Prüfkommando parametrisierbar. Beispielsweise kann durch einen oder mehrere Parameter des Prüfkommandos die vorbestimmte Sequenz von Operationen, die durch die integrierte Schaltung aufgrund des Empfangs des Prüfkommandos ausgeführt werden soll, spezifiziert werden, insbesondere auch welche der Verbraucher wie oft und in welcher Reihenfolge parallel oder sequenziell anzusteuern sind, um eine maximale Leistungsaufnahme der integrierten Schaltung oder eine typische Leistungsaufnahme im Wirkbetrieb zu simulieren. Je nach Ausführungsform kann auch vorgesehen sein, dass ein Parameter des Prüfkommandos eine zugelassene Anzahl von Wiederholungen des Wartezeit-Verlängerungssignals angibt, die als zusätzliche Voraussetzung für die Erzeugung des Signals zur Signalisierung des Bestehens der Prüfung durch den Terminal nicht überschritten werden darf.

Nach Ausführungsformen der Erfindung ist die Ausführung des Prüfkommandos durch das Chipkartebetriebssystem derart implementiert, dass - konfigurierbar über entsprechende Kommandoparameter - ein Stromverbrauch der Chip-Hardware erzeugt werden kann, der dem Wirkbetrieb nahe kommt oder einen möglichst hohen Stromverbrauch generiert oder auch nur bestimmte Komponenten der Chip-Hardware in konfigurierbarer Art und Weise verwendet. Die durch das Prüfkommando angesprochenen HW-Komponenten umfassen dabei typischerweise die folgenden:
- Schreiben von nicht-flüchtigen elektronischen Speichern (NVM- non-volatile memory), z.B. EEPROM oder FLASH,
- Verwenden des Hardware Zufallsgenerators (HW-PRNG -pseudo random number generator),
- Verwenden von Hardware (HW)-Co-Prozessoren für symmetrische Kryptoverfahren (DES, 3DES, AES, u.a.),
- Verwenden von HW-Co-Prozessoren für asymmetrische Kryptoverfahren (RSA, ECDSA, u.a.),
- Verwenden der Recheneinheit des µC (micro controllers), z.B. eines Prozessorkernels,
- Verwenden der MMU (memory management unit),

Dabei sollen für einen maximalen Stromverbrauch der HW möglichst viele HW-Komponenten parallel mit höchster Performanz und Auslastung betrieben werden, was zweckmäßigerweise mittels Interrupt-gesteuertem Programmablauf realisiert wird. Die Auswahl und die jeweilige Betriebsart der parallel betriebenen HW-Komponenten soll dabei mittels Parameter wählbar über das Prüfkommando gesteuert werden. Zusätzlich soll mittels Parameter des Prüfkommandos auch die Anzahl und/oder zeitliche Dauer der Nutzung der jeweiligen HW-Komponenten gesteuert werden können.

Ausführungsformen der Erfindung sind besonders vorteilhaft, da die Prüfung der integrierten Schaltung schon vor der Personalisierung des nicht-flüchtigen elektronischen Speichers erfolgen kann und dennoch aussagekräftig ist, sodass defekte integrierte Schaltungen schon in einen frühen Stadium des Produktionsprozesses aussortiert werden können. Insbesondere kann eine solche Prüfung auch bereits durchgeführt werden, bevor der Dokumentenkörper geformt ist, insbesondere dann, wenn sich die integrierte Schaltung und deren Antenne auf einem Träger befindet, der vor der Formung des Dokumentenkörpers geprüft wird.

Ausführungsformen der Erfindung sind ferner besonders vorteilhaft, da durch die Ausführung des Prüfkommandos durch die integrierte Schaltung der Wirkbetrieb simuliert wird, obwohl vor der Personalisierung des geschützten nicht-flüchtigen elektronischen Speichers eine Ausführung von zumindest einigen der Chipkartenkommandos, die zur Ausführung von kryptografischen Funktionen dienen, aufgrund einer entsprechenden Konfiguration der integrierten Schaltung, insbesondere von deren Betriebssystem, nicht möglich ist. Eine solche Konfiguration der elektronischen Schaltung ist vorteilhaft, um ein höchstmögliches Maß an Sicherheit zu gewährleisten, indem erst nach Abschluss des Personalisierungsvorgangs ein externer Zugriff auf den geschützten nicht-flüchtigen elektronischen Speicher ermöglicht wird.

Nach Ausführungsformen der Erfindung hat die integrierte Schaltung einen nicht-flüchtigen Programmspeicher, in dem erste und zweite Programminstruktionen gespeichert sind. Die Ausführung der ersten Programminstruktionen kann nur mit dem Prüfkommando gestartet werden, wohingegen die Ausführung der zweiten Programminstruktionen aufgrund eines anderen Chipkartenkommando im Wirkbetrieb, das heißt nach der Personalisierung, erfolgen kann. Je nach Ausführungsform kann es für den Übergang in den Wirkbetrieb erforderlich sein, dass das Dokument aus seinem Erstbenutzungsstatus in seinen Benutzt-Status übergeht, wie an sich aus WO 2009/027240 bekannt.

Beispielsweise handelt es sich bei dem Chipkartenkommando um ein Kommando zur Initiierung eines externen Lesezugriffs auf den geschützten nicht-flüchtigen elektronischen Speicher, beispielsweise von einem Chipkartenterminal oder von einem eID-Provider-Computersystem über das Internet. Durch ein solches Kommando wird eine kryptografische Funktion des Dokuments aufgerufen, die durch die zweiten Programminstruktionen implementiert ist, um durch Ausführung der kryptografischen Funktion die Erfüllung einer kryptografischen Zugriffsbedingung für den angeforderten externen Zugriff zu prüfen. Eine solche kryptografische Funktion kann beispielsweise ein Challenge-Response-Protokoll, symmetrische oder asymmetrische Ver- und/oder Entschlüsselungen, eine oder mehrere Diffie-Hellman-Schlüsselaustausche, beispielsweise zur Durchführung des PACE-Protokolls, insbesondere ein oder mehrere Punktpunktmultiplikationen auf einer elliptischen Kurve und/oder die Erzeugung einer Pseudorandomzufallszahl oder eine Kombination zweier oder mehrerer solcher kryptografischen Operationen beinhalten.

Solche kryptografischen Operationen sind im Allgemeinen relativ rechenintensiv und erfordern einen dementsprechend relativ hohen Energiebetrag zur Aufnahme durch die integrierte Schaltung. Wenn hingegen die in die Schaltung eingekoppelte Leistung relativ gering ist, so kann dies je nach Ausführungsform dazu führen, dass die kryptografische Funktion entweder nicht, nicht vollständig oder sehr langsam durchgeführt wird, Letzteres insbesondere dann, wenn die integrierte Schaltung ihre Taktrate je nach der eingekoppelten Leistung regelt.

Eine geringe eingekoppelte Leistung führt dann zu einer geringen Taktrate, was wiederum eine entsprechend langsame Durchführung der kryptografischen Funktion zur Folge hat. Um Exemplare der integrierten Schaltung mit einer kontaktlosen HF-Schnittstelle auszusortieren, die nicht den Qualitätsanforderungen entspricht, und die beispielsweise zu einer zu langsamen Durchführung der kryptografischen Funktion im Wirkbetrieb führen würde, wird die Ausführung der kryptografischen Funktion im Wirkbetrieb durch die ersten Programminstruktionen hinsichtlich der Leistungsaufnahme und der damit verbundenen Verarbeitungsgeschwindigkeit simuliert.

Nach Ausführungsformen der Erfindung erfolgt eine solche Simulation der Leistungsaufnahme der integrierten Schaltung, indem durch die ersten Programminstruktionen ein vorgegebenes Datenvolumen von Pseudorandomdaten erzeugt und verschlüsselt wird, wobei dies in einem Arbeitsspeicher der integrierten Schaltung erfolgt, da die ersten Programminstruktionen nicht auf den geschützten nicht-flüchtigen elektronischen Speicher zugreifen dürfen, um ein Maximum an Sicherheit zu gewährleisten.

Die für die Durchführung der Verschlüsselung der Pseudorandomdaten benötigten kryptografischen Parameter sind fest vorgegeben und in einem nicht-flüchtigen elektronischen Speicher der integrierten Schaltung gespeichert, damit zur Durchführung der ersten Programminstruktionen immer dieselben Verarbeitungsschritte für eine konsistente Prüfung durchgeführt werden.

Nach einer Ausführungsform der Erfindung ist ein Verbraucher Teil der integrierten Schaltung oder an die integrierte Schaltung angeschlossen. Durch Ausführung des Prüfkommandos wird der Verbraucher ein- oder mehrfach ein- und ausgeschaltet, um die Leistungsaufnahme des Verbrauchers im Wirkbetrieb zu simulieren. Nur wenn die Leistungsaufnahme bei der Prüfung ausreichend ist, kann die integrierten Schaltung innerhalb des Toleranzbereichs die Prüfantwort senden, nachdem der Verbraucher ein- oder mehrfach durch Ausführung des Prüfkommandos an- und ausgeschaltet worden ist.

Nach einer Ausführungsform der Erfindung handelt es sich bei dem Verbraucher um eine Anzeigevorrichtung, die als separate Komponente oder als Teil der integrierten Schaltung ausgebildet sein kann, wie es an sich aus WO 2011/023577 bekannt ist.

Nach einer Ausführungsform der Erfindung kann es sich bei dem Verbraucher um einen Sensor handeln, insbesondere einen biometrischen Sensor zur Erfassung von biometrischen Daten für die Authentifizierung eines Nutzers gegenüber der integrierten Schaltung, wie zum Beispiel einen Fingerabdrucksensor oder eine Kamera für die Durchführung von Gesichtsbiometrie oder zur Erfassung eines Irisscan des Nutzers.

Nach einer Ausführungsform der Erfindung erfolgt die Prüfung der integrierten Schaltung, nachdem diese zusammen mit ihrer Antenne auf einen Träger aufgebracht worden ist. Beispielsweise wird die Antenne mit einer Silberleitpaste auf dem Träger aufgedruckt. Die Anschlusskontakte der integrierten Schaltung werden mit der Antenne zum Beispiel mit einem leitfähigen Kleber oder einer anderen Verbindungstechnik elektrisch kontaktiert, wobei die integrierte Schaltung dabei gleichzeitig mit dem Träger verbunden werden kann. Insbesondere kann es sich bei der integrierten Schaltung um eine gehauste oder ungehauste Schaltung, insbesondere ein sogenanntes Bare Die, handeln.

Nach einer Ausführungsform der Erfindung erfolgt eine erste Prüfung der integrierten Schaltung bereits vor der Aufbringung der integrierten Schaltung auf den Träger und/oder vor deren Verbindung mit der Antenne. In diesem Fall werden die Anschlusskontakte der integrierten Schaltung, beispielsweise deren sogenannte Contact Pads, durch Messkontakte, insbesondere sogenannte Chip Probes, ankontaktiert, um die Prüfung durchzuführen.

In diesem Fall erfolgt die Einkopplung von Energie über die Messkontakte sowie auch das Senden des Prüfkommandos. Der zweite Toleranzbereich, der für diese initiale Prüfung der integrierten Schaltung verwendet wird, ist dabei vorzugsweise kleiner als der erste Toleranzbereich, der verwendet wird, nachdem die Schaltung bereits mit der Antenne verbunden worden ist, da das Ansprechverhalten der integrierten Schaltung über die Messkontakte im Allgemeinen schneller sein wird, als bei Einkopplung über die Antenne.

Nach einer Ausführungsform der Erfindung ist der Träger, auf dem sich die integrierte Schaltung und deren Antenne befinden, schichtförmig ausgebildet. Aus dem Träger und weiteren Papier- und/oder Kunststoffschichten wird dann ein mehrlagiger Dokumentenkörper zur Herstellung eines Dokuments geformt, beispielsweise indem Schichten auflaminiert werden.

Nach einer Ausführungsform der Erfindung erfolgt die Prüfung der integrierten Schaltung abschließend erneut, nachdem der Dokumentenkörper hergestellt worden ist. Erst nach dieser abschließenden Prüfung wird die Personalisierung des nicht-flüchtigen elektronischen Speichers durchgeführt.

Ausführungsformen der Erfindung sind besonders vorteilhaft, da integrierte Schaltungen, die hinsichtlich ihrer kontaktlosen HF-Schnittstelle und/oder deren Antenne und/oder der elektrischen Kontaktierung der Antenne mit der HF-Schnittstelle nicht den Qualitätsanforderungen entsprechen, jeweils zu einem frühzeitigen Zeitpunkt in dem Produktionsprozess der Dokumente erkannt und aussortiert werden können. Hierdurch steigt insgesamt der Durchsatz bei der Produktion von Dokumenten und die Kosten des Ausschuss werden reduziert, da ein erheblicher Anteil von nicht den Qualitätsanforderungen genügenden Exemplaren der integrierten Schaltung entweder schon vor dem Aufbringen auf den Träger oder vor der Formung des Dokumentenkörpers aussortiert werden.

In einem weiteren Aspekt betrifft die Erfindung ein entsprechendes Dokument.

Ausführungsformen eines solchen Dokuments sind besonders vorteilhaft, da das Dokument einerseits schon vor seiner Personalisierung vollständig prüfbar ist, indem nämlich mithilfe des Prüfkommandos die Durchführung einer vorbestimmten Sequenz von Operationen durch die integrierte Schaltung bewirkt wird, um die Leistungsaufnahme im Wirkbetrieb zu simulieren, und dies andererseits ohne eine Einbuße hinsichtlich der Sicherheit des Dokuments erfolgt, da die integrierten Schaltung, beispielsweise deren Betriebssystem, so konfiguriert ist, dass die Ausführung des Prüfkommandos nur in dem ersten unpersonalisierten Zustand möglich ist. Empfängt die integrierte Schaltung das Prüfkommando hingegen in dem zweiten personalisierten Zustand, so wird dieses nicht ausgeführt und es erfolgt keine oder keine valide Prüfantwort darauf.

In einem weiteren Aspekt betrifft die Erfindung ein Prüfsystem mit einem Terminal und einer Ausführungsform eines erfindungsgemäßen Dokuments. Die integrierte Schaltung des Dokuments wird vor der Personalisierung geprüft, indem der Terminal Energie einkoppelt und das Prüfkommando sendet. Liegt die Zeitdauer zwischen dem Senden des Prüfkommandos und dem Empfang der Prüfantwort innerhalb des Toleranzbereichs, so erzeugt das Terminal ein Signal, welches das Bestehen der Prüfung signalisiert, oder im gegenteiligen Fall ein Signal, das signalisiert, dass die Prüfung nicht bestanden wurde.

In einem weiteren Aspekt betrifft die Erfindung ein Personalisierungssystem mit einem erfindungsgemäßen Prüfsystem und einer Personalisierungsvorrichtung. Wenn die Personalisierungsvorrichtung von dem Prüfsystem das Signal empfängt, wonach die integrierte Schaltung die Prüfung bestanden hat, so erfolgt durch die Personalisierungsvorrichtung eine Personalisierung des geschützten nicht-flüchtigen elektronischen Speichers der integrierten Schaltung, beispielsweise indem ein oder mehrere Attribute betreffend den Inhaber des Dokuments, wie zum Beispiel dessen Name, Anschrift, Geburtsdatum und/oder Attribute betreffend das Dokument selbst, wie zum Beispiel dessen Gültigkeitsdauer oder die ausstellende Behörde, in dem geschützten nicht-flüchtigen elektronischen Speicher gespeichert werden.

Nach Abschluss dieser Personalisierung geht die elektronische Schaltung in ihren zweiten personalisierten Zustand irreversibel über, sodass dann das Prüfkommando nicht mehr von der integrierten Schaltung ausführbar ist, und die Ausführung anderer Chipkartenkommandos ermöglicht wird, insbesondere um die Ausführung einer kryptografische Funktion zur Prüfung einer kryptografischen Zugriffsbedingung für einen externen Zugriff auf den personalisierten nicht-flüchtigen elektronischen Speicher zu ermöglichen.

Im Weiteren werden Ausführungsformen der Erfindung mit Bezugnahme auf die Zeichnungen näher erläutert. Es zeigen:
- Figur 1: ein Blockdiagramm einer Ausführungsform eines erfindungsgemäßen Personalisierungssystems,
- Figur 2: eine Ausführungsform eines erfindungsgemäßen Verfahrens.

Elemente der nachfolgenden Ausführungsformen, die einander entsprechen oder gleichen, werden jeweils mit denselben Bezugszeichen gekennzeichnet.

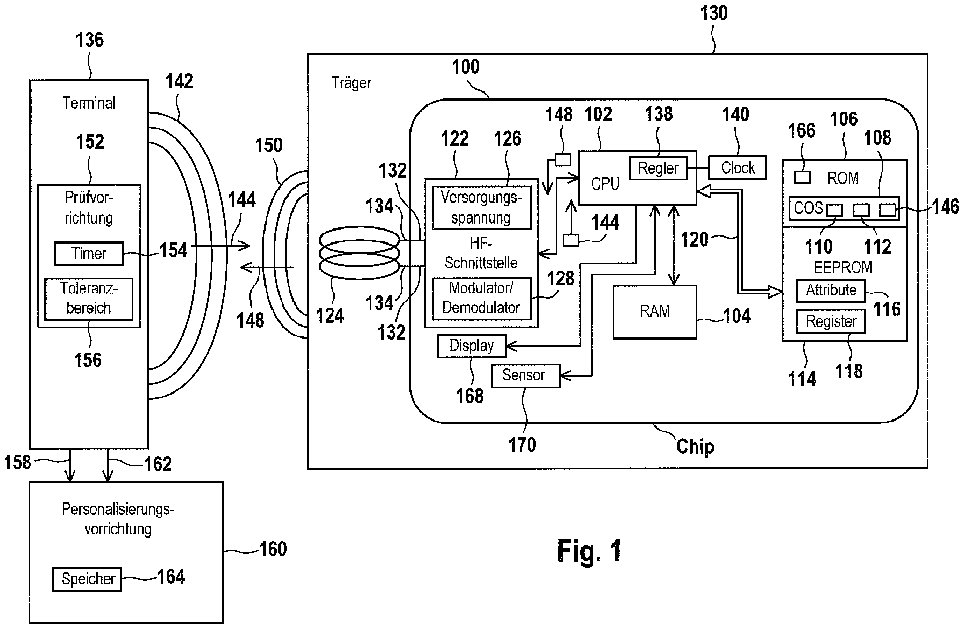

Die Figur 1 zeigt eine Ausführungsform einer integrierten Schaltung, die hier als Chip 100 ausgebildet ist. Der Chip 100 beinhaltet einen Mikroprozessor 102, beispielsweise eine Central Processing Unit (CPU), mit einem Arbeitsspeicher 104, das heißt eine sogenannte Random Access Memory (RAM).

Der Chip 100 hat ferner einen nicht-flüchtigen elektronischen Speicher, dessen Speicherinhalte unveränderlich sind, das heißt, ein sogenanntes Read Only Memory (ROM) 106.

Ein Chipkartenbetriebssystem (COS) 108 oder zumindest wesentliche Teile davon werden bereits bei der Herstellung des Chips 100 über eine sogenannte ROM-Maske in das ROM 106 unveränderlich eingebracht.

Bei der hier betrachteten Ausführungsform beinhaltet das Chipkartenbetriebssystem 108 erste Programminstruktionen 110 und zweite Programminstruktionen 112.

Der Chip 100 hat ferner einen personalisierbaren und geschützten nicht-flüchtigen elektronischen Speicher, wie zum Beispiel ein Electrically Erasable Programmable Read-Only Memory (EEPROM) 114, in dem bei einer Personalisierung der integrierten Schaltung bzw. des Dokuments, in welches die integrierte Schaltung eingebracht worden ist, Attribute 116 gespeichert werden können, die schutzbedürftig sind, da es sich beispielsweise um persönliche Angaben zu dem Inhaber des Dokuments, dessen biometrische Merkmale oder Attribute des Dokuments selbst handelt. Zumindest einige solcher Attribute 116 dürfen im Wirkbetrieb des Dokuments nur nach vorheriger Authentisierung und Berechtigungsprüfung von einer dazu berechtigten Stelle aus dem Dokument ausgelesen werden.

Das EEPROM 114 hat ein Statusregister 118, das angibt, ob sich der Chip 100 in seinem ersten unpersonalisierten Zustand oder in seinem zweiten personalisierten Zustand befindet. Beispielsweise ist der Inhalt des Statusregisters 118 in dem ersten unpersonalisierten Zustand logisch "0" und in dem zweiten personalisierten Zustand logisch "1".

Das ROM 106 und das EEPROM 114 sind mit dem Mikroprozessor 102 über einen internen Daten- und Kommandobus 120 des Chips 100 verbunden. Ein Zugriff auf das ROM 106 und das EEPROM 114 kann also ausschließlich von dem Mikroprozessor 102 erfolgen, um einen wirksamen Schutz gegen unautorisierte externe Zugriffe zu gewährleisten.

Das Chipkartenbetriebssystem 108 des Chips 100 ist so konfiguriert, dass eine Ausführung der ersten Programminstruktionen 110 grundsätzlich nur dann möglich ist, wenn der Chip 100 seinen ersten Zustand hat, das heißt, wenn der Inhalt des Statusregisters 118 logisch 0 ist. In diesem unpersonalisierten Zustand ist hingegen eine Ausführung der zweiten Programminstruktionen 112 zur Ausführung anderer Chipkartenkommandos nicht möglich.

Andererseits ist das Chipkartenbetriebssystem 108 so konfiguriert, dass eine Ausführung der ersten Programminstruktionen 110 grundsätzlich nicht möglich ist, wenn sich der Chip in seinem zweiten Zustand befindet, das heißt, wenn der Inhalt des Statusregisters 118 logisch 1 ist. In diesem Fall ist hingegen die Ausführung der zweiten Programminstruktionen 112 zur Ausführung von Chipkartenkommandos möglich.

Der Chip 100 hat eine kontaktlose HF-Schnittstelle 122, über die beispielsweise ein RFID- oder ein NFC-Kommunikationsverfahren implementiert wird. Neben der Kommunikation dient die HF-Schnittstelle 122 auch zur Einkopplung der für den Betrieb des Chips 100 notwendigen Leistung.

Hierzu hat die HF-Schnittstelle 122 eine Schaltung 126, um aus der über eine Antenne 124 eingekoppelte Trägerwelle eine Versorgungsspannung für den Chip 100 zu gewinnen. Ferner hat die HF-Schnittstelle 122 eine Schaltung 128 mit einem Demodulator zur Demodulation der Trägerwelle 142, um Chipkartenkommandos zu empfangen, sowie mit einem Modulator, um Antworten auf Chipkartenkommandos zu senden.
Die Antenne 124 befindet sich auf einem Träger 130. Beispielsweise handelt es sich bei dem Träger 130 um eine Kunststoffschicht, auf die die Antenne 124 mit ein oder mehreren Antennenwicklungen aufgebracht ist, beispielsweise drucktechnisch mit einer Silberleitpaste.

Der Chip 100 hat Kontaktstellen, beispielsweise sogenannte Pads 132, an welchen die Antenne 124 mit Kontaktierungen 134 elektrisch verbunden ist. Bei dieser Kontaktierung kann es sich zum Beispiel um einen anisotrop leitfähigen Kleber (anisotropic conductive adhesive - ACA) handeln, wie es an sich beispielsweise aus DE 10 2010 028 444 A1 bekannt ist.

Aus der Antenne 124, den Kontaktierungen 134, den Pads 132 und der Eingangsimpedanz der HF-Schnittstelle 122 wird ein Schwingkreis gebildet, der eine geeignete Güte und Resonanzfrequenz aufweisen muss, um eine Kommunikation zwischen einem Terminal 136 und dem Chip kontaktlos zu ermöglichen und die für den Betrieb des Chips 100 erforderliche Leistung einzukoppeln. Dies setzt eine geeignete Impedanz der Antenne 124, einen geeigneten Widerstand und Kapazität der Kontaktierungen 134, einen geeigneten Übergangswiderstand der Pads 132 sowie die Einhaltung einer vorgegebenen Eingangsimpedanz der HF-Schnittstelle 122 voraus.

Kommt es hinsichtlich dieser elektrischen Eigenschaften zu zu großen Abweichungen von den betreffenden Soll-Werten, so kann dies dazu führen, dass das mithilfe des Chips 100 hergestellte Dokument nicht den Qualitätsanforderungen genügt oder nicht funktionsfähig ist. Insbesondere kann es aufgrund einer zu geringen Güte des Schwingkreises oder aufgrund einer Resonanzfrequenz, die außerhalb des Normbereichs liegt, dazu kommen, dass nur eine relativ geringe Leistung über die Antenne 124 von dem Terminal 136 eingekoppelt wird, sodass der Chip 100 mit einer entsprechend geringen Taktrate oder gar nicht arbeitet.

Zur Regelung der Taktrate des Chips 100 kann der Mikroprozessor 102 einen Regler 138 aufweisen, der in Abhängigkeit von der Höhe der an dem Mikroprozessor 102 von der HF-Schnittstelle 122 angelegten Versorgungsspannung einen Taktgeber, das heißt eine sogenannte Clock 140 des Chips regelt, sodass die Clock 140 bei einer geringen Versorgungsspannung ein Clocksignal mit einer geringeren Frequenz abgibt, als dies bei einer höheren Versorgungsspannung der Fall ist.

Die Antenne kann sich auch auf einer anderen Schicht befinden, die mit dem Träger 130 z.B. über ein via verbunden ist, um den Schwingkreis mit dem Chip 100 zu bilden. In diesem Fall wird der Verbund aus dieser andern Schicht und dem Träger 130 mit dem Chip 100 geprüft.

Zur Prüfung des Chips 100 wird beispielsweise wie folgt vorgegangen:
1. Von dem Terminal 136 wird eine elektromagnetische Trägerwelle 142 abgestrahlt, durch die die für den Betrieb des Chips 100 erforderliche Leistung in den Schwingkreis des Chips 100 eingekoppelt wird. Hierdurch baut die HF-Schnittstelle 122 eine Versorgungsspannung auf, sodass die Clock 140 anschwingt.
2. Der Terminal 136 sendet dann ein Prüfkommando 144 durch eine entsprechende Modulation der Trägerwelle 142. Bei dem Prüfkommando 144 handelt es sich um ein Chipkartenkommando, durch welches die Ausführung der ersten Programminstruktionen 110 gestartet werden soll.
3. Der Chip 100 empfängt das Prüfkommando 144 über den Schwingkreis, sodass die HF-Schnittstelle 122 das empfangene Prüfkommando 144 an den Mikroprozessor 102 ausgibt.
4. Durch Ausführung des Chipkartenbetriebssystems 108 wird durch den Mikroprozessor 102 geprüft, ob sich der Chip 100 in seinem ersten oder zweiten Zustand befindet, wozu auf das Statusregister 118 über den Bus 120 zugegriffen wird. Nur unter der Voraussetzung, dass sich der Chip in seinem ersten unpersonalisierten Zustand befindet, das heißt der Inhalt des Registers 118 muss logisch 0 sein, wird das Prüfkommando 144 durch den Mikroprozessor 102 ausgeführt, das heißt es wird von dem Mikroprozessor 102 eine durch die ersten Programminstruktionen 110 vorbestimmte Sequenz von Operationen durchgeführt. Zur Ausführung des Prüfkommandos 144, das heißt der ersten Programminstruktionen 110, greift der Mikroprozessor 102 nicht auf das EEPROM 114 zu, sondern auf den Arbeitsspeicher 104, um die Sicherheit des EEPROMs 114 nicht infrage zu stellen.
   Beispielsweise beinhaltet das Chipkartenbetriebssystem 108 einen Pseudorandomgenerator 146, durch dessen Ausführung der Mikroprozessor 102 ein vorgegebenes Datenvolumen von Pseudozufallszahlen erzeugt, welche der Mikroprozessor 102 verschlüsselt oder unverschlüsselt in den Arbeitsspeicher 104 speichert, um die Leistungsaufnahme des Chips im Wirkbetrieb zu simulieren.
5. Nach Ausführung des Prüfkommandos 144 erzeugt der Mikroprozessor 102 eine Prüfungsantwort 148, durch welche die Ausführung des Prüfkommandos bestätigt wird.
6. Die Prüfungsantwort 148 wird über die HF-Schnittstelle 122 des Chips 100 kontaktlos über eine Trägerwelle 150 gesendet und empfangen.

Das Terminal 136 beinhaltet eine Prüfvorrichtung 152 mit einem Timer 154. Durch Aussendung des Prüfkommandos 154 wird der Timer 154 der Prüfvorrichtung 152 gestartet und durch Empfang der Prüfantwort 148 wird der Timer gestoppt.

Der sich daraus ergebende Timerwert gibt die Zeitdauer zwischen dem Senden des Prüfkommandos 144 und dem Empfang der Prüfantwort 148 an und ist charakteristisch für die Verarbeitungsgeschwindigkeit, mit der der Chip 100 die ersten Programminstruktionen 110 ausgeführt hat und damit für die Taktrate, welche durch die Leistungsaufnahme und damit die Qualität des Schwingkreises gegeben ist. Von der Prüfvorrichtung 152 wird geprüft, ob der sich so ergebende Timerwert innerhalb eines in der Prüfvorrichtung 152 gespeicherten Toleranzbereichs 156 liegt.

Wenn dies der Fall ist, gibt die Prüfvorrichtung 152 ein erstes Signal 158 an eine Personalisierungsvorrichtung 160 aus; im gegenteiligen Fall gibt die Prüfvorrichtung 152 ein Signal zweites 162 an die Personalisierungsvorrichtung aus, wonach es sich bei dem Chip 100 um Ausschuss handelt.

Wenn die Personalisierungsvorrichtung 160 das Signal 158 empfängt, so greift die Personalisierungsvorrichtung auf deren Speicher 164 zu, um die dort für die Personalisierung des Chips 100 gespeicherten Attribute 116 auszulesen und in das EEPROM 114 zu schreiben. Die Übertragung der in den Speicher 164 gespeicherten Attribute 116 in das EEPROM 114 von der Personalisierungsvorrichtung 160 kann kontaktbehaftet erfolgen oder über den Terminal 136, der die Attribute 116 an den Chip 100 sendet, sodass diese von dem Mikroprozessor 102 über den Bus 120 in dem EEPROM 114 gespeichert werden, was das Chipkartenbetriebssystem 108 nur solange erlaubt, als das Statusregister 118 noch den logischen Wert 0 hat.

Nach Abschluss der Übertragung der Attribute 116 von der Personalisierungsvorrichtung 160 zu dem Chip 100 und nach deren Speicherung in dem EEPROM 114 wird von dem Chipkartenbetriebssystem 108 das Statusregister 118 auf logisch 1 gesetzt, wodurch das EEPROM 114 "abgeschlossen wird", das heißt im Weiteren kann ein externer Zugriff auf das EEPROM 114 nur nach Prüfung einer kryptografischen Zugriffsbedingung durch Ausführung eines entsprechenden Chipkartenkommandos, das heißt der zweiten Programminstruktionen 112, erfolgen.

Nach Ausführungsformen der Erfindung sind ein oder mehrere kryptografische Parameter 166 ebenfalls in dem ROM 106 gespeichert. Auf diese kryptografischen Parameter 166 greift das Chipkartenbetriebssystem 108 zur Ausführung der ersten Programminstruktionen 110 zu. Hierbei kann es sich beispielsweise um einen symmetrischen Schlüssel zur Verschlüsselung der von dem Pseudorandomgenerator 146 gelieferten Daten, ein asymmetrisches Schlüsselpaar und/oder Domainparameter für eine elliptische Kurvenkryptografie handeln. Alternativ oder zusätzlich können der oder die Parameter 166 auch in dem EEPROM 114 gespeichert werden.
Hierdurch wird die Leistungsaufnahme des Chips 100 in dem zweiten personalisierten Zustand, das heißt im Wirkbetrieb, durch Ausführung der ersten Programminstruktionen simuliert.

Beispielsweise wird durch die zweiten Programminstruktionen 112 ein kryptografisches Protokoll implementiert, um die Erfüllung einer kryptografischen Bedingung zu prüfen, die Voraussetzung dafür ist, dass ein externer Lesezugriff auf die in dem EEPROM 114 gespeicherten Attribute 116 erfolgen kann. Hierzu kann die Erzeugung einer Challenge, einer Ver- oder Entschlüsselung mit einem symmetrischen oder asymmetrischen Schlüssel, ein Diffie-Hellman-Schlüsselaustausch und/oder eine Punktmultiplikation auf einer elliptischen Kurve oder eine Kombination zweier oder mehrerer solcher kryptografischer Operationen gehören, insbesondere zur Implementierung eines Basic Access Control (BAC) und/oder Extended Access Control (EAC) und/oder eines PACE-Protokolls oder eines anderen Challenge-Response-Protokolls und/oder eines anderen Protokolls zur Authentifizierung und/oder Berechtigungsprüfung als Voraussetzung für das Auslesen ein oder mehrerer der Attribute 116 aus dem EEPROM 114.

Um die erforderliche Leistungsaufnahme des Chips 100 im Wirkbetrieb für die Durchführung der zweiten Programminstruktionen aufgrund eines entsprechenden Chipkartenkommandos zu simulieren, werden durch Ausführung der ersten Programminstruktionen 110 kryptografisch Operationen ähnlicher Komplexität und ähnlichen Umfangs durchgeführt.

Der Chip 100 kann einen oder mehrere Verbraucher beinhalten, die von dem Mikroprozessor 102 angesteuert werden können. Hierbei kann es sich beispielsweise um eine Anzeigevorrichtung 168, das heißt ein sogenanntes Display, und/oder einen Sensor 170, beispielsweise einen biometrischen Sensor, handeln. Zur Prüfung, ob der Schwingkreis des Chips 100 die zur Energieversorgung der Anzeigevorrichtung 168 und/oder des Sensors 170 erforderliche Qualität aufweist, können die ersten Programminstruktionen 110 so ausgebildet sein, dass durch deren Ausführung von dem Mikroprozessor 102 die Anzeigevorrichtung 168 und/oder der Sensor 170 angesteuert werden, um sie ein- und ausschalten, um so die Leistungsaufnahme im Wirkbetrieb des Chips zu simulieren. Zusätzlich können die ersten Programminstruktionen 110 auch in diesem Fall zur Simulation der Leistungsaufnahme für die Durchführung der zweiten Programminstruktionen 112 im Wirkbetrieb ausgebildet sein.

Alternativ oder zusätzlich kann der Chip 100 einen oder mehrere weitere oder andere Verbraucher beinhalten oder an solche angeschlossen sein. Hierbei kann es sich beispielsweise um einen nicht-flüchtigen Speicher, einen Hardware-Zufallszahlengenerator, einen Hardware-Coprozessor, insbesondere einen Hardware-Coprozessor für symmetrische und/oder asymmetrische kryptografische Verfahren, eine Recheneinheit und/oder eine Memory Management Unit handeln.

Das Prüfkommando 144 kann parametrisierbar sein, um die Sequenz von aufgrund des Prüfkommandos durchzuführenden Operationen zu spezifizieren, beispielsweise hinsichtlich der ein- und auszuschaltenden Verbraucher. In diesem Fall wird der Toleranzbereich 156 in Abhängigkeit von der Parametrisierung des Prüfkommandos 144 von der Prüfvorrichtung 152 gewählt. Hierzu kann die Prüfvorrichtung 152 beispielsweise einen sogenannten Lookup-Table beinhalten, in dem jeder möglichen Wahl von Parametern für das Prüfkommando 144 ein Toleranzbereich 156 zugeordnet ist, in dem die Zeitdauer zwischen dem Senden des entsprechend parametrisierten Prüfkommandos 144 und dem Empfang der daraufhin gesendeten Prüfantwort 148 fallen muss, damit das Signal 158 abgegeben wird. Beispielsweise gehört zu den Attributen 116 auch ein Passfoto oder eine Sequenz von Passfotos des Inhabers des Dokuments. Im Wirkbetrieb des Dokuments kann dann so vorgegangen werden, dass nach Einkopplung von Energie in die HF-Schnittstelle 122 der Mikroprozessor 102 auf die in dem EEPROM 114 gespeicherten Bilddaten zugreift, um diese über die Anzeigevorrichtung 168 auszugeben. Die Anzeige einer Bildsequenz auf einer Anzeigevorrichtung eines Dokuments ist als solche aus WO 2009/053249 A1 bekannt.

Je nach Ausführungsform kann es erforderlich sein, dass sich der Inhaber des Dokuments gegenüber dem Chip 100 zunächst authentifiziert, bevor der Chip 100 auf über den Schwingkreis empfangene Chipkartenkommandos reagiert. Eine solche biometrische Authentifizierung kann zusätzlich oder alternativ zu einer Authentifizierung mittels einer PIN vorgesehen sein.

Bei dem Träger 130 kann es sich zum Beispiel um eine Kunststofffolie aus einem Polymer, wie zum Beispiel Polycarbonat, eine Papierschicht oder einen Verbund aus einem Papier und einer Polymerschicht handeln. Die Antennenwindungen der Antenne 124 werden auf den Träger 130 aufgebracht, beispielsweise drucktechnisch mit einer Silberleitpaste. Ebenso wird der Chip 100 auf den Träger 130 aufgebracht, beispielsweise als Chipmodul oder als sogenanntes Bare Die. Die Befestigung und elektrische Kontaktierung des Chips 100 mit der Antenne 124 kann durch an sich bekannte Bonding-Techniken, wie zum Beispiel einen anisotrop leitfähigen Kleber erfolgen.

Nach Herstellung des Trägers 130 mit dem Chip 100 und der mit dem Chip kontaktierten Antenne 124 wird der Chip 100 und dessen Schwingkreis wie oben dargestellt geprüft. Ergibt die Prüfung, dass der Chip 100 die Prüfung besteht, so wird der Träger 130 mit ein oder mehreren weiteren papier- und/oder kunststoffbasierten Schichten zu einem mehrschichtigen Dokumentenkörper zusammengefügt, beispielsweise durch Laminieren, vergleiche hierzu beispielsweise DE 10 2007 052 948 A1.

Das so hergestellte Dokument kann dann erneut geprüft werden, bevor die Personalisierung erfolgt. Alternativ oder zusätzlich kann eine Prüfung des Chips 100 auch bereits erfolgen, bevor dieser auf den Träger aufgebracht wird.
Nach Ausführungsformen der Erfindung ist der Chip 100 zur Ausgabe eines Wartezeit-Verlängerungssignals, das heißt eines sogenannten WTX-Signals 172, ausgebildet. Hierzu kann eine entsprechende Funktion in dem Chipkartenbetriebssystem 108 vorgesehen sein. Wenn die über die Trägerwelle 142 in den Chip 100 eingekoppelte Leistung relativ gering und damit die von der Clock 140 erzeugte Taktrate relativ langsam ist, so erzeugt der Chip 100 das WITX-Signal 172, um dem Terminal 136 zu signalisieren, dass sich die Wartezeit auf die Antwort auf das zuvor gesendete Chipkartenkommando verlängern soll.

Wenn der Schwingkreis des Chips 100 eine nicht den Qualitätsanforderungen genügende Güte und/oder Resonanzfrequenz hat, so wird die zur Prüfung des Chips 100 eingekoppelte Trägerwelle 142 zur Einkopplung einer relativ geringen Leistung und damit zu einer geringen Taktrate der Clock 140 führen. Wenn der Terminal in diesem Fall das Prüfkommando 144 sendet, so wird der Chip 100 -je nach Ausführungsform - daraufhin das WTX-Signal 172 über die HF-Schnittstelle 122 senden, um von dem Terminal 136 eine Verlängerung der Wartezeit auf die Prüfantwort 148 anzufordern. Der Empfang des WTX-Signals 172 durch den Terminal 136 signalisiert dem Terminal 136 aber, dass die Einkopplung der Leistung in den Chip 100 nicht zureichend ist, sodass der Chip 100 bzw. der Träger 130 mit dem darauf befindlichen Chip und der Antenne 124 bzw. der Dokumentenkörper als Ausschuss betrachtet wird und der Terminal 136 daraufhin das Signal 162 ausgibt, welches dies signalisiert.

Nach einer Ausführungsform der Erfindung ist der Chip 100 dazu ausgebildet, ein Feldstärke-Erhöhungssignal 174 zu erzeugen und über die HF-Schnittstelle 122 abzugeben, um von dem Terminal 136 eine Erhöhung der Feldstärke, mit der die Trägerwelle 142 abgesendet wird, anzufordern. Ein solches Signal wird dann von dem Chip 100 erzeugt, wenn die eingekoppelte Leistung relativ gering ist, was sich beispielsweise in einer relativ geringen Taktrate der Clock 140 äußert. Wenn der Terminal 136 das Feldstärke-Erhöhungssignal 174 empfängt, so wird das Signal 162 erzeugt, da der Empfang des Feldstärke-Erhöhungssignals 174 darauf hinweist, dass der Schwingkreis des Chips 100 nicht den Qualitätsanforderungen genügt.

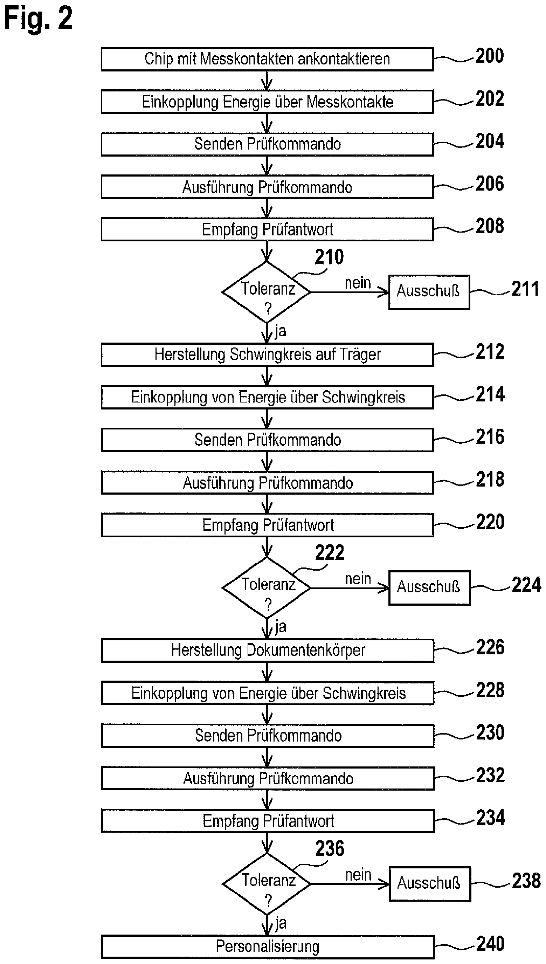

Die Figur 2 zeigt eine Ausführungsform eines Verfahrens zur Prüfung einer integrierten Schaltung für die Herstellung und Personalisierung eines Dokuments. Für eine erste Prüfung wird zunächst der unbeschaltete Chip 100 geprüft, noch bevor er mit seiner Antenne 124 verbunden worden ist. Hierzu werden die Pads 132 des Chips mit Messkontakten, das heißt den sogenannten Probes, ankontaktiert, um sie beispielsweise mit dem Terminal 136 elektrisch zu verbinden. In dem Schritt 202 wird dann elektrische Energie über diese Messkontakte in den Chip 100 eingekoppelt, sodass die Clock 140 anschwingt und der Mikroprozessor 102 beginnt zu arbeiten.

In dem Schritt 204 wird dann über die Messkontakte das Prüfkommando 144 an den Chip 100 gesendet und dort in dem Schritt 206 ausgeführt, da sich der Chip 100 in seinem unpersonalisierten Zustand befindet. Durch das Senden des Prüfkommandos 144 wird der Timer 154 gestartet. Die aufgrund der Ausführung des Prüfkommandos 144 von dem Chip 100 erzeugte Prüfantwort 148 wird dann in dem Schritt 208 über die Messkontakte empfangen, der Timer 154 wird gestoppt und die Zeitdauer zwischen dem Senden und Empfangen wird durch Auslesen des Timerwert erfasst. Der Timer 154 wird hierdurch zurückgesetzt.

In dem Schritt 210 wird dann geprüft, ob die Zeitdauer zwischen dem Senden des Prüfkommandos und dem Schritt 204 der Empfang der Prüfantwort 208 innerhalb eines ersten Toleranzbereichs liegt. Ist dies nicht der Fall, so handelt es sich bei dem Chip 100 um Ausschuss und das Prüfverfahren wird in dem Schritt 210 abgebrochen.

Im gegenteiligen Fall wird in dem Schritt 212 der Schwingkreis hergestellt, indem die Antenne 124 und der Chip 100 auf den Träger 130 aufgebracht werden. Anschließend wird in dem Schritt 214 Energie über die Trägerwelle 152 in den Schwingkreis eingekoppelt, sodass erneut die Clock 140 anschwingt und der Mikroprozessor 102 zu arbeiten beginnt. In dem Schritt 216 wird das Prüfkommando 144 von dem Terminal 136 gesendet und in dem Schritt 218 von dem Chip 100 ausgeführt, da sich dieser immer noch in seinem ersten unpersonalisierten Zustand befindet.

In dem Schritt 220 empfängt der Terminal 136 die Prüfantwort 148 von dem Chip 100 und die Zeitdauer wird mit dem Timer 154 analog zu Schritt 208 erfasst. In dem Schritt 222 wird daraufhin geprüft, ob die Zeitdauer zwischen dem Senden des Prüfkommandos 144 und dem Empfang der Prüfantwort 148 innerhalb eines zweiten Toleranzbereichs liegt. Wenn dies nicht der Fall ist, so handelt es sich bei dem hergestellten Träger 130 um Ausschuss und die Prüfung wird in dem Schritt 224 abgebrochen.

Im gegenteiligen Fall wird in dem Schritt 226 der Dokumentenkörper des Dokuments hergestellt, indem der Träger 130 mit einer oder mehreren papier- und/oder kunststoffbasierten Schichten zum Beispiel durch Laminieren verbunden wird. Daraufhin erfolgt erneut eine Prüfung des Chips 100 und dessen Schwingkreises durch Ausführung der Schritte 228, 230, 232, 234 und 236, die analog zu den Schritten 214 bis 222 durchgeführt werden, wobei in dem Schritt 236 geprüft wird, ob die Zeitdauer innerhalb eines dritten Toleranzbereichs liegt, der identisch zu dem zweiten Toleranzbereich sein kann.

Ergibt diese Prüfung, dass die Zeitdauer nicht in dem dritten Toleranzbereich liegt, so ist der hergestellte Dokumentenkörper Ausschuss und die Prüfung wird in dem Schritt 238 abgebrochen. Im gegenteiligen Fall signalisiert die Prüfvorrichtung 152 des Terminals 136, dass der hergestellte Dokumentenkörper die Prüfung bestanden hat, sodass dann durch die Personalisierungsvorrichtung 160 eine Personalisierung des geschützten nicht-flüchtigen elektronischen Speichers, das heißt des EEPROMs 114, erfolgt.

### Bezugszeichenliste

- 100: Chip
- 102: Mikroprozessor
- 104: Arbeitsspeicher
- 106: ROM
- 108: Chipkartenbetriebssystem
- 110: erste Programminstruktionen
- 112: zweite Programminstruktionen
- 114: EEPROM
- 116: Attribute
- 118: Statusregister
- 120: Bus
- 122: HF-Schnittstelle
- 124: Antenne
- 126: Schaltung
- 128: Schaltung
- 130: Träger
- 132: Pad
- 134: Kontaktierung
- 136: Terminal
- 138: Regler
- 140: Clock
- 142: Trägerwelle
- 144: Prüfkommando
- 146: Pseudorandomgenerator
- 148: Prüfantwort
- 150: Trägerwelle
- 152: Prüfvorrichtung
- 154: Timer
- 156: Toleranzbereich
- 158: Signal
- 160: Personalisierungsvorrichtung
- 162: Signal
- 164: Speicher
- 166: kryptografischer Parameter
- 168: Anzeigevorrichtung
- 170: Sensor
- 172: WTX-Signal
- 174: Feldstärke-Erhöhungssignal

## Patentansprüche

1. Verfahren zur Prüfung einer integrierten Schaltung (100) mit einer kontaktlosen HF-Schnittstelle (122), wobei die integrierte Schaltung einen personalisierbaren und geschützten nicht-flüchtigen elektronischen Speicher (114) aufweist und die integrierte Schaltung (100) einen ersten unpersonalisierten Zustand und einen zweiten personalisierten Zustand hat, wobei ein Übergang von dem ersten in den zweiten Zustand nicht reversibel ist, wobei die HF-Schnittstelle (122) zum Empfangen von Chipkartenkommandos und zum Senden von Antworten auf Chipkartenkommandos ausgebildet ist, wobei zu den Chipkartenkommandos ein Prüfkommando (144) und zu den Antworten eine Prüfantwort (148) auf das Prüfkommando (144) gehört, wobei die integrierte Schaltung (100) so konfiguriert ist, dass eine Ausführung des Prüfkommandos (144) und eine Beantwortung des Prüfkommandos (144) mit der Prüfantwort (148) nur dann erfolgt, wenn sich die integrierte Schaltung (100) in dem ersten Zustand befindet, wobei die Ausführung des Prüfkommandos (144) eine Durchführung einer vorbestimmten Sequenz von Operationen durch die integrierte Schaltung (100) bewirkt, wobei das Verfahren die folgenden Schritte umfasst:
a) Einkoppeln (202; 214; 228) von Energie zum Betrieb der integrierten Schaltung (100) von einem Terminal (136) in die kontaktlosen HF-Schnittstelle (122) über eine Trägerwelle (142),
b) Senden (204; 216; 230) des Prüfkommandos (144) von dem Terminal (136),
c) Empfangen (208; 220; 234) des Prüfkommandos (144) über die kontaktlose HF-Schnittstelle (122) durch die integrierte Schaltung (100),
d) unter der Voraussetzung, dass sich die integrierte Schaltung in ihrem ersten unpersonalisierten Zustand befindet, Ausführen (206; 218; 232) des Prüfkommandos (144) durch die integrierte Schaltung (100) und Senden der Prüfantwort (148) nach dem Ausführen des Prüfkommandos (144) zum Empfangen durch den Terminal (136),
e) Erfassung (208; 220; 234) einer Zeitdauer zwischen dem Senden (204) des Prüfkommandos (144) und dem Empfangen der Prüfantwort (148) durch den Terminal (136),
f) Erzeugen eines Signals (158) durch das Terminal (136) zur Signalisierung des Bestehens der Prüfung unter der Voraussetzung (210; 222; 236), dass die erfasste Zeitdauer innerhalb eines vorbestimmten Toleranzbereichs (156) liegt.

2. Verfahren nach Anspruch 1, wobei die integrierte Schaltung (100) einen nicht-flüchtigen Programmspeicher (106) aufweist, in dem zumindest erste Programminstruktionen (110) und zweite Programminstruktionen (112) gespeichert sind, wobei die integrierte Schaltung (100) so konfiguriert ist, dass durch zumindest eines der Chipkartenkommandos eine kryptografische Funktion, die durch die zweiten Programminstruktionen implementiert wird, aufrufbar ist, um eine Zugriffsbedingung für einen externen Zugriff auf den nicht-flüchtigen elektronischen Speicher (114) zu prüfen, wobei durch die ersten Programminstruktionen die Durchführung der vorbestimmten Sequenz von Operationen durch die integrierte Schaltung (100) implementiert wird, um die zur Ausführung der kryptografischen Funktion durch die zweiten Programminstruktionen erforderliche Leistungsaufnahme über die HF-Schnittstelle zu simulieren, wobei die integrierte Schaltung so konfiguriert ist, dass die Ausführung der ersten Programminstruktionen nur durch das Prüfkommando (144) erfolgen kann, wenn sich die integrierte Schaltung (100) im ersten unpersonalisierten Zustand befindet, und wobei die integrierte Schaltung (100) so konfiguriert ist, dass der Aufruf der kryptografischen Funktion der zweiten Programminstruktionen über das Chipkartenkommando nur dann möglich ist, wenn sich die integrierte Schaltung im zweiten personalisierten Zustand befindet.

3. Verfahren nach Anspruch 2, wobei die kryptografische Funktion die Erzeugung einer Challenge, eine Ver- oder Entschlüsselung mit einem symmetrischen oder asymmetrischen Schlüssel, einen Diffie-Hellman Schlüsselaustausch und/oder eine Punktmultiplikation auf einer elliptischen Kurve oder eine Kombination zweier oder mehrerer solcher kryptografischen Operationen beinhaltet.

4. Verfahren nach Anspruch 2 oder 3, wobei aufgrund des Startens der ersten Programminstruktionen durch Empfang des Prüfkommandos (144) durch die ersten Programminstruktionen ein vorgegebenes Datenvolumen von Pseudorandomdaten erzeugt und ausschließlich in einem Arbeitsspeicher (104) der integrierten Schaltung (100) verschlüsselt gespeichert wird, wobei die für die Verschlüsselung der Pseudorandomdaten durch Ausführung der ersten Programminstruktionen erforderlichen kryptografischen Parameter (166) in einem nicht-flüchtigen elektronischen Speicher (106, 114) der integrierten Schaltung (100) unveränderlich gespeichert sind.

5. Verfahren nach einem der vorgehenden Ansprüche, wobei die integrierte Schaltung dazu ausgebildet ist, ein Wartezeit-Verlängerungssignal (172) abzugeben, um eine Wartezeit des Terminals (136) auf die Antwort der integrierten Schaltung auf eines der Chipkartenkommandos zu verlängern, wobei der Terminal (136) so konfiguriert ist, dass das Signal (158) nur unter der zusätzlichen Voraussetzung erzeugt wird, dass das Wartezeit-Verlängerungssignal aufgrund des Sendens des Prüfkommandos (144) von dem Terminal (136) nicht oder nur eine vorgegebene maximalen Anzahl von Wiederholungen empfangen wird.

6. Verfahren nach einem der vorhergehenden Ansprüche, wobei die integrierte Schaltung (100) dazu ausgebildet ist, ein Feldstärke-Erhöhungssignal (174) zu senden, um die Feldstärke der Trägerwelle (142) zu erhöhen, wobei der Terminal (136) dazu ausgebildet ist, das Signal (158) nur unter der zusätzlichen Voraussetzung zu erzeugen, dass der Terminal (136) das Feldstärke-Erhöhungssignal nicht empfängt.

7. Verfahren nach einem der vorhergehenden Ansprüche, wobei ein Verbraucher (168, 170) Teil der integrierten Schaltung (100) ist oder an die integrierte Schaltung (100) angeschlossen ist, wobei durch das Ausführen des Prüfkommandos (144) der Verbraucher (168, 170) eingeschaltet wird.

8. Verfahren nach Anspruch 7, wobei es sich bei dem Verbraucher (168, 170) um eine Anzeigevorrichtung (168) handelt, insbesondere um eine Anzeigevorrichtung zur Anzeige von in dem zweiten personalisierten Zustand in dem nicht-flüchtigen elektronischen Speicher (114) gespeicherten Bilddaten, und/oder einen Sensor (170), insbesondere einen biometrischen Sensor zur Erfassung von biometrischen Daten für die Authentifizierung eines Nutzers gegenüber der integrierten Schaltung, um die Ausführung einer Chipkartenfunktion, insbesondere der kryptografischen Funktion, durch die integrierte Schaltung freizuschalten, wobei durch das Einschalten eine Betriebsspannung an den Verbraucher angelegt wird.

9. Verfahren nach Anspruch 7 oder 8, wobei es sich bei dem Verbraucher um einen weiteren nicht-flüchtigen Speicher, einen Hardware-Zufallszahlengenerator, einen Hardware-Coprozessor, insbesondere einen Hardware-Coprozessor für symmetrische und/oder asymmetrische kryptografische Verfahren, eine Recheneinheit und/oder eine Memory Management Unit handelt.

10. Verfahren nach einem der vorhergehenden Ansprüche, wobei das Prüfkommando (144) parametrisierbar ist, um die Sequenz der durchzuführenden Operationen festzulegen und wobei der Toleranzbereich in Abhängigkeit von der Parametrisierung des Prüfkommandos (144) von dem Terminal (136) ausgewählt wird.

11. Verfahren nach einem der vorhergehenden Ansprüche, wobei die integrierten elektronische Schaltung (100) und eine Antenne (124) für die kontaktlose HF-Schnittstelle (122) vor Durchführung der Prüfung auf einen Träger (130) aufgebracht werden, sodass das Empfangen des Prüfkommandos (144) und das Senden der Prüfantwort (148) über die Antenne (124) erfolgen, wobei für den Toleranzbereich ein erster Toleranzbereich verwendet wird.

12. Verfahren nach Anspruch 11, wobei zur Prüfung der integrierten Schaltung (100) vor ihrer Verbindung mit der Antenne (124) die integrierten Schaltung (100) mit Messkontakten kontaktiert wird und das Empfangen des Prüfkommandos (144) sowie das Senden der Prüfantwort (148) über die Messkontakte erfolgt, wobei als Toleranzbereich ein von dem ersten Toleranzbereich verschiedener zweiter Toleranzbereich verwendet wird.

13. Verfahren nach Anspruch 11 oder 12, wobei der Träger (130) schichtförmig ausgebildet ist und aus dem Träger (130) mit der darauf befindlichen Antenne (124) und der integrierten Schaltung (100) unter der Voraussetzung der Signalisierung des Bestehens der Prüfung aus weiteren Papier- und/oder Kunststoffschichten ein mehrlagiger Dokumentenkörper zur Herstellung eines Dokuments geformt werden.

14. Verfahren nach Anspruch 13, wobei die Prüfung der integrierten Schaltung (100) durch Ausführung der Schritte a) bis e) nach Herstellung des Dokumentenkörpers erneut durchgeführt wird, und nach Bestehung dieser nochmaliger Prüfung die Personalisierung des nicht-flüchtigen elektronischen Speichers (114) durchgeführt wird, wodurch die integrierten Schaltung (100) irreversibel in ihren zweiten personalisierten Zustand gebracht wird.

15. Dokument mit einem Dokumentenkörper umfassend eine integrierte Schaltung (100), die eine kontaktlos HF-Schnittstelle (122) aufweist, welche mit einer Antenne (124) des Dokuments elektrisch verbunden ist, wobei die integrierte Schaltung (100) einen personalisierbaren und geschützten nicht-flüchtigen elektronischen Speicher (114) aufweist und die integrierte Schaltung einen ersten unpersonalisierten Zustand und einen zweiten personalisierten Zustand hat, wobei ein Übergang von dem ersten in den zweiten Zustand nicht reversibel ist, wobei die HF-Schnittstelle zum Empfangen von Chipkartenkommandos und zum Senden von Antworten auf Chipkartenkommandos ausgebildet ist, wobei zu den Chipkartenkommandos ein Prüfkommando (144) und zu den Antworten eine Prüfantwort (148) auf das Prüfkommando gehört, wobei die integrierte Schaltung (100) so konfiguriert ist, dass eine Ausführung des Prüfkommandos und eine Beantwortung des Prüfkommandos mit der Prüfantwort nur dann erfolgt, wenn sich die integrierte Schaltung in ihrem ersten Zustand befindet, wobei die Ausführung des Prüfkommandos die Durchführung einer vorbestimmten Sequenz von Operationen durch die integrierte Schaltung bewirkt, wobei die integrierte Schaltung einen nicht-flüchtigen Programmspeicher (106) aufweist, in dem zumindest erste Programminstruktionen (110) und zweite Programminstruktionen (112) gespeichert sind, wobei die integrierte Schaltung so konfiguriert ist, dass durch zumindest eines der Chipkartenkommandos eine kryptografische Funktion, die durch die zweiten Programminstruktionen implementiert wird, aufrufbar ist, um eine Zugriffsbedingung für einen externen Zugriff auf den nicht-flüchtigen elektronischen Speicher zu prüfen, wobei durch die ersten Programminstruktionen die Durchführung der vorbestimmten Sequenz von Operationen durch die integrierte Schaltung implementiert wird, um die zur Ausführung der kryptografischen Funktion durch die zweiten Programminstruktionen erforderliche Leistungsaufnahme über die HF-Schnittstelle zu simulieren, wobei die integrierte Schaltung so konfiguriert ist, dass die Ausführung der ersten Programminstruktionen nur durch das Prüfkommando erfolgen kann, wenn sich die integrierte Schaltung in ihrem ersten unpersonalisierten Zustand befindet, und wobei die integrierte Schaltung so konfiguriert ist, dass der Aufruf der kryptografischen Funktion der zweiten Programminstruktionen über das Chipkartenkommando nur dann möglich ist, wenn sich die integrierte Schaltung in ihrem zweiten personalisierten Zustand befindet.

16. Dokument nach Anspruch 15, wobei die kryptografische Funktion die Erzeugung einer Challenge, eine Ver- oder Entschlüsselung mit einem symmetrischen oder asymmetrischen Schlüssel, einen Diffie-Hellman Schlüsselaustausch und/oder eine Punktmultiplikation auf einer elliptischen Kurve oder eine Kombination zweier oder mehrerer solcher kryptografischen Operationen beinhaltet.

17. Dokument nach Anspruch 15 oder 16, wobei die integrierte Schaltung so konfiguriert ist, dass durch Ausführung der ersten Programminstruktionen ein vorgegebenes Datenvolumen von Pseudorandomdaten erzeugt und in einem Arbeitsspeicher der integrierten Schaltung verschlüsselt gespeichert wird, wobei die für die Verschlüsselung der Pseudorandomdaten durch Ausführung der ersten Programminstruktionen erforderlichen kryptografischen Parameter in einem nicht-flüchtigen elektronischen Speicher der integrierten Schaltung unveränderlich gespeichert sind.

18. Dokument nach einem der vorhergehenden Ansprüche 15 bis 17, wobei ein Verbraucher (168, 170) Teil der integrierten Schaltung ist oder an die integrierte Schaltung angeschlossen ist, wobei die integrierte Schaltung so konfiguriert ist, dass durch Ausführung des Prüfkommandos der Verbraucher eingeschaltet wird.

19. Dokument nach Anspruch 18, wobei es sich bei dem Verbraucher um eine Anzeigevorrichtung handelt, insbesondere um eine Anzeigevorrichtung zur Anzeige von in dem zweiten personalisierten Zustand in dem nicht-flüchtigen elektronischen Speicher gespeicherten Bilddaten, und/oder einen Sensor, insbesondere einen biometrischen Sensor zur Erfassung von biometrischen Daten für die Authentifizierung eines Nutzers gegenüber der integrierten Schaltung, um die Ausführung einer Chipkartenfunktion, insbesondere der kryptografischen Funktion, durch die integrierte Schaltung freizuschalten, wobei durch das Einschalten eine Betriebsspannung an den Verbraucher angelegt wird.

20. Dokument nach einem der vorhergehenden Ansprüche 15 bis 19, wobei es sich um ein elektronisches Wert- oder Sicherheitsdokument, insbesondere ein elektronische Ausweisdokument, insbesondere einen Reisepass, Personalausweis, Visum, Führerschein, Fahrzeugschein, Fahrzeugbrief, Firmenausweis, Gesundheitskarte oder ein anderes ID-Dokument, insbesondere eine Chipkarte, ein Zahlungsmittel, insbesondere eine Banknote, Bankkarte oder Kreditkarte, einen Frachtbrief, Eintrittskarte oder einen sonstige Berechtigungsnachweis handelt.

21. Prüfsystem mit einem Terminal (136) und einem Dokument nach einem der Ansprüche 15 bis 20, wobei das Prüfsystem zur Durchführung eines Verfahrens nach einem der Ansprüche 1 bis 10 konfiguriert ist.

22. Personalisierungssystem mit einem Prüfsystem nach Anspruch 21 und mit einer Personalisierungsvorrichtung (160) zur Personalisierung des nicht-flüchtigen elektronischen Speicher des Dokuments, wobei das Prüfsystem mit der Personalisierungsvorrichtung verbunden ist, sodass das von dem Terminal zur Signalisierung des Bestehens der Prüfung erzeugte Signal (158) an die Personalisierungsvorrichtung übertragen wird, sodass die Personalisierungsvorrichtung daraufhin den nicht-flüchtigen elektronischen Speicher des Dokuments personalisiert.

## Claims

1. A method for testing an integrated circuit (100) comprising a contactless RF interface (122), the integrated circuit comprising a personalizable and protected non-volatile electronic memory (114), and the integrated circuit (100) having a first non-personalized state and a second personalized state, a transition from the first state into the second state not being reversible, the RF interface (122) being designed to receive chip card commands and to transmit responses to chip card commands, a test command (144) being associated with the chip card commands and a test response (148) to the test command (141) being associated with the responses, the integrated circuit (100) being configured so that the test command (144) is executed and the test command (144) is responded to with the test response (148) only when the integrated circuit (100) is in the first state, the execution of the test command (144) causing a predetermined sequence of operations to be performed by the integrated circuit (100), the method including the following steps:
a) coupling (202; 214; 228) energy for the operation of the integrated circuit (100) from a terminal (136) into the contactless RF interface (122) via a carrier wave (142);
b) transmitting (204; 216; 230) the test command (144) from the terminal (136);
c) receiving (208; 220; 234) the test command (144) via the contactless RF interface (122) by the integrated circuit (100);
d) provided that the integrated circuit is in the first non-personalized state thereof, executing (206; 218; 232) the test command (144) by the integrated circuit (100), and transmitting the test response (148) after the test command (144) has been executed for reception by the terminal (136);
e) recording (208; 220; 234) a time duration between the transmission (204) of the test command (144) and the reception of the test response (148) by the terminal (136); and
f) generating a signal (158) by the terminal (136) for signaling that the test has been passed, provided (210; 222; 236) that the recorded time duration is within a predetermined tolerance range (156).

2. The method according to claim 1, wherein the integrated circuit (100) comprises a non-volatile program memory (106) in which at least first program instructions (110) and second program instructions (112) are stored, the integrated circuit (100) being configured so that a cryptographic function, which is implemented by the second program instructions, can be invoked by at least one of the chip card commands so as to check an access condition for an external access to the non-volatile electronic memory (114), the first program instructions implementing the performance of the predetermined sequence of operations by the integrated circuit (100) so as to simulate the power consumption required for the execution of the cryptographic function by the second program instructions via the RF interface, the integrated circuit being configured so that the execution of the first program instructions by way of the test command (144) can only take place when the integrated circuit (100) is in the first non-personalized state, and the integrated circuit (100) being configured so that the invocation of the cryptographic function of the second program instructions by way of the chip card command is only possible when the integrated circuit is in the second personalized state.

3. The method according to claim 2, wherein the cryptographic function includes the generation of a challenge, an encryption or a decryption by way of a symmetric or asymmetric key, a Diffie-Hellman key exchange and/or a point multiplication on an elliptic curve, or a combination of two or more such cryptographic operations.

4. The method according to claim 2 or 3, wherein, due to the start of the first program instructions as a result of the reception of the test command (144), a predefined data volume of pseudorandom data is generated by the first program instructions and stored exclusively in a working memory (104) of the integrated circuit (100) in encrypted form, the cryptographic parameters (166) required for the encryption of the pseudorandom data by the execution of the first program instructions being stored in a non-volatile electronic memory (106, 114) of the integrated circuit (100) in unalterable form.

5. The method according to any one of the preceding claims, wherein the integrated circuit is designed to output a waiting period extension signal (172) so as to extend a waiting period of the terminal (136) for the response of the integrated circuit to one of the chip card commands, the terminal (136) being configured so that the signal (158) is only generated when it is additionally provided that the waiting period extension signal is not received, or only a predefined maximum number of repetitions is received, by the terminal (136) as a result of the transmission of the test command (144).

6. The method according to any one of the preceding claims, wherein the integrated circuit (100) is designed to transmit a field strength increase signal (174) so as to increase the field strength of the carrier wave (142), the terminal (136) being designed to generate the signal (158) only when it is additionally provided that the terminal (136) does not receive the field strength increase signal.

7. The method according to any one of the preceding claims, wherein a consumer (168, 170) is part of the integrated circuit (100) or is connected to the integrated circuit (100), the consumer (168, 170) being activated as a result of the execution of the test command (144).

8. The method according to claim 7, wherein the consumer (168, 170) is a display device (168), in particular a display device for displaying image data stored in the second personalized state in the non-volatile electronic memory (114), and/or a sensor (170), in particular a biometric sensor for detecting biometric data for authenticating a user with respect to the integrated circuit, so as to enable the execution of a chip card function, in particular the cryptographic function, by the integrated circuit, the activation causing an operating voltage to be applied to the consumer.

9. The method according to claim 7 or 8, wherein the consumer is a further non-volatile memory, a hardware random number generator, a hardware coprocessor, in particular a hardware coprocessor for symmetric and/or asymmetric cryptographic methods, a processing unit and/or a memory management unit.

10. The method according to any one of the preceding claims, wherein the test command (144) is parameterizable so as to establish the sequence of the operations to be performed, and the tolerance range is selected by the terminal (136) as a function of the parameterization of the test command (144).

11. The method according to any one of the preceding claims, wherein the integrated electronic circuit (100) and an antenna (124) for the contactless RF interface (122) are applied to a carrier (130) before carrying out the test, so that the reception of the test command (144) and the transmission of the test response (148) take place via the antenna (124), a first tolerance range being used for the tolerance range.

12. The method according to claim 11, wherein the integrated circuit (100) is contacted with measuring contacts for testing the integrated circuit (100) prior to being connected to the antenna (124), and the reception of the test command (144) and the transmission of the test response (148) take place via the measuring contacts, a second tolerance range that is different from the first tolerance range being used as the tolerance range.

13. The method according to claim 11 or 12, wherein the carrier (130) has a layered design, and a multi-layer document body for producing a document is formed from the carrier (134), comprising the antenna (124) and the integrated circuit (100) located thereon, and from further paper and/or plastic layers, provided that it is signaled that the test has been passed.

14. The method according to claim 13, wherein the test of the integrated circuit (100) is carried out again after the document body has been produced by executing the steps a) to e), and the personalization of the non-volatile electronic memory (114) is carried out after this renewed test has been passed, whereby the integrated circuit (100) is irreversibly brought into the second personalized state thereof.

15. A document including a document body, comprising an integrated circuit (100), which has a contactless RF interface (122) that is electrically connected to an antenna (124) of the document, the integrated circuit (100) comprising a personalizable and protected non-volatile electronic memory (114), and the integrated circuit having a first non-personalized state and a second personalized state, a transition from the first state into the second state not being reversible, the RF interface being designed to receive chip card commands and to transmit responses to chip card commands, a test command (144) being associated with the chip card commands and a test response (148) to the test command being associated with the responses, the integrated circuit (100) being configured so that the test command is executed and the test command is responded to with the test response only when the integrated circuit is in the first state thereof, the execution of the test command causing a predetermined sequence of operations to be performed by the integrated circuit, the integrated circuit comprising a non-volatile program memory (106) in which at least first program instructions (110) and second program instructions (112) are stored, the integrated circuit being configured so that a cryptographic function, which is implemented by the second program instructions, can be invoked by at least one of the chip card commands so as to check an access condition for an external access to the non-volatile electronic memory, the first program instructions implementing the performance of the predetermined sequence of operations by the integrated circuit so as to simulate the power consumption required for the execution of the cryptographic function by the second program instructions via the RF interface, the integrated circuit being configured so that the execution of the first program instructions by way of the test command can only take place when the integrated circuit is in the first non-personalized state thereof, and the integrated circuit being configured so that the invocation of the cryptographic function of the second program instructions by way of the chip card command is only possible when the integrated circuit is in the second personalized state thereof.

16. The document according to claim 15, wherein the cryptographic function includes the generation of a challenge, an encryption or a decryption by way of a symmetric or asymmetric key, a Diffie-Hellman key exchange and/or a point multiplication on an elliptic curve, or a combination of two or more such cryptographic operations.

17. The document according to claim 15 or 16, wherein the integrated circuit is configured so that a predefined data volume of pseudorandom data is generated as a result of the execution of the first program instructions and stored in a working memory of the integrated circuit in encrypted form, the cryptographic parameters required for the encryption of the pseudorandom data by the execution of the first program instructions being stored in a non-volatile electronic memory of the integrated circuit in unalterable form.

18. The document according to any one of the preceding claims 15 to 17, wherein a consumer (168, 170) is part of the integrated circuit or is connected to the integrated circuit, the integrated circuit being configured so that the consumer is activated as a result of the execution of the test command.

19. The document according to claim 18, wherein the consumer is a display device, in particular a display device for displaying image data stored in the second personalized state in the non-volatile electronic memory, and/or a sensor, in particular a biometric sensor for detecting biometric data for authenticating a user with respect to the integrated circuit, so as to enable the execution of a chip card function, in particular the cryptographic function, by the integrated circuit, the activation causing an operating voltage to be applied to the consumer.

20. The document according to any one of the preceding claims 15 to 19, wherein this is an electronic value or security document, in particular an electronic identification document, in particular a passport, an identification card, a visa, a driver's license, a vehicle registration, a vehicle title, a company ID card, a health insurance card or other ID document, in particular a chip card, a payment instrument, in particular a bank note, a bank card or a credit card, a bill of lading, an admission ticket or other proof of authorization.

21. A test system, comprising a terminal (136) and a document according to any one of claims 15 to 20, wherein the test system is configured to carry out a method according to any one of claims 1 to 10.

22. A personalization system, comprising a test system according to claim 21 and comprising a personalization device (160) for personalizing the non-volatile electronic memory of the document, wherein the test system is connected to the personalization device so that the signal (158) generated by the terminal for signaling that the test has been passed is transmitted to the personalization device, so that the personalization device thereupon personalizes the non-volatile electronic memory of the document.

## Revendications

1. Procédé de vérification d'un circuit intégré (100) doté d'une interface de radiofréquence RF sans contact (122), dans lequel le circuit intégré présente une mémoire (114) électronique non volatile protégée et pouvant être personnalisée et le circuit intégré (100) a un premier état non personnalisé et un deuxième état personnalisé, où une transition du premier vers le deuxième état n'est pas réversible, où l'interface de RF (122) est conçue pour la réception de commandes de carte à puce et pour la transmission de réponses suite à des commandes de carte à puce, où une commande de vérification (144) fait partie de manière complémentaire des commandes de carte à puce, et une réponse de vérification (148) suite à la commande de vérification (144) fait partie des réponses, où le circuit intégré (100) est configuré de telle manière qu'une exécution de la commande de vérification (144) et une réponse à la commande de vérification (144) n'ont lieu avec la réponse de vérification (148) que si le circuit intégré (100) se trouve dans le premier état, où l'exécution de la commande de vérification (144) provoque une exécution d'une séquence prédéterminée d'opérations par le circuit intégré (100), où le procédé comprend les étapes suivantes :
a) injection (202 ; 214 ; 228) d'énergie pour le fonctionnement du circuit intégré (100) depuis un terminal (136) dans l'interface de RF (122) sans contact par le biais d'une onde porteuse (142),
b) envoi (204 ; 216 ; 230) de la commande de vérification (144) depuis le terminal (136),
c) réception (208 ; 220 ; 234) de la commande de vérification (144) par le biais de l'interface de RF (122) sans contact par le circuit intégré (100),
d) à la condition que le circuit intégré se trouve dans son premier état non personnalisé, exécution (206 ; 218 ; 232) de la commande de vérification (144) par le circuit intégré (100) et envoi de la réponse de vérification (148) après l'exécution de la commande de vérification (144) pour une réception par le terminal (136),
e) détection (208 ; 220 ; 234) d'un intervalle de temps entre l'envoi (204) de la commande de vérification (144) et la réception de la réponse de vérification (148) par le terminal (136),
f) génération d'un signal (158) par le terminal (136) pour la signalisation de l'existence de la vérification à la condition (210 ; 222 ; 236) que l'intervalle de temps détecté se trouve dans un domaine de tolérance (156) prédéterminé.

2. Procédé selon la revendication 1, dans lequel le circuit intégré (100) présente une mémoire de programme (106) non volatile, dans laquelle au moins des premières instructions de programme (110) et des deuxièmes instructions de programme (112) sont stockées, dans lequel le circuit intégré (100) est configuré de telle manière qu'au moins une fonction cryptographique, qui est mise en oeuvre par les deuxièmes instructions de programme, peut être invoquée par au moins l'une des commandes de carte à puce, afin de vérifier une condition d'accès pour un accès externe sur la mémoire (114) électronique non volatile, où, par les premières instructions de programme, l'exécution de la séquence d'opérations prédéterminée est mise en oeuvre par le circuit intégré (100) afin de simuler, par le biais de l'interface de RF, la prise en charge nécessaire pour l'exécution de la fonction cryptographique par les deuxièmes instructions de programme, où le circuit intégré est configuré de telle manière que l'exécution des premières instructions de programme ne peut avoir lieu que par la commande de vérification (144) lorsque le circuit intégré (100) se trouve dans le premier état non personnalisé, et où le circuit intégré (100) est configuré de telle manière que l'implication de la fonction cryptographique des deuxièmes instructions de programme par le biais de la commande de carte à puce n'est possible que si le circuit intégré se trouve dans le deuxième état personnalisé.

3. Procédé selon la revendication 2, dans lequel la fonction cryptographique contient la génération d'un défi, un cryptage ou un décryptage avec une clé symétrique ou asymétrique, un échange de clés de Diffie-Hellman et/ou une multiplication de points sur une courbe elliptique ou une combinaison de deux ou de plusieurs telles opérations cryptographiques.

4. Procédé selon la revendication 2 ou 3, dans lequel, en raison du démarrage des premières instructions de programme, un volume de données prédéterminé de données pseudo-aléatoires a été généré par la réception de la commande de vérification (144) et est enregistré à l'état chiffré exclusivement dans une mémoire de travail (104) du circuit intégré (100), où les paramètres cryptographiques (166) nécessaires pour le chiffrement des données pseudo-aléatoires sont stockés par l'exécution des premières instructions de programme à l'état inchangé dans une mémoire (106, 114) électronique non volatile du circuit intégré (100).

5. Procédé selon l'une des revendications précédentes, dans lequel le circuit intégré est conçu pour délivrer un signal de prolongement d'un délai d'attente (172) afin de prolonger un délai d'attente du terminal (136) pour une réponse du circuit intégré suite à l'une des commandes de carte à puce, où le terminal (136) est configuré de telle manière que le signal (158) n'est généré que sous la condition complémentaire que le signal de prolongement du délai d'attente n'est pas réceptionné en raison de l'envoi de la commande de vérification (144) à partir du terminal ou qu'uniquement un nombre maximal prédéterminé de répétitions est réceptionné.

6. Procédé selon l'une des revendications précédentes, dans lequel le circuit intégré (100) est conçu pour émettre un signal d'élévation d'intensité de champ (174) afin d'augmenter l'intensité de champ de l'onde porteuse (142), où le terminal (136) est conçu pour générer le signal (158) uniquement à la condition supplémentaire que le terminal (136) ne réceptionne pas le signal d'élévation de l'intensité de champ.

7. Procédé selon l'une des revendications précédentes, dans lequel un système consommateur (168,170) fait partie du circuit intégré (100) ou est associé au circuit intégré (100), où le système consommateur (168, 170) est activé par l'exécution de la commande de vérification (144).

8. Procédé selon la revendication 7, dans lequel, dans le cas du système consommateur (168, 170), il s'agit d'un dispositif d'affichage (168), en particulier, un dispositif d'affichage pour l'affichage de données d'images stockées dans la mémoire (114) électronique non volatile dans le deuxième état personnalisé, et/ou d'un capteur (170), en particulier, un capteur biométrique pour la détection de données biométriques pour l'authentification d'un utilisateur vis-à-vis du circuit intégré afin d'activer l'exécution d'une fonction de carte à puce, en particulier, une fonction cryptographique, par le circuit intégré, où une tension de fonctionnement est appliquée au système consommateur par l'activation.

9. Procédé selon la revendication 7 ou 8, dans lequel, dans le cas du système consommateur, il s'agit d'une nouvelle mémoire non volatile, d'un générateur de nombres aléatoires de matériel, d'un coprocesseur de matériel, en particulier, un coprocesseur de matériel destiné à des procédés cryptographiques symétriques et/ou asymétriques, d'une unité de calcul et/ou d'une unité de gestion de mémoire.

10. Procédé selon l'une des revendications précédentes, dans lequel la commande de vérification (144) peut être paramétrée afin de fixer la séquence des opérations à exécuter et dans lequel le domaine de tolérance est choisi en fonction du paramétrage de la commande de vérification (144) à partir du terminal (136).

11. Procédé selon l'une des revendications précédentes, dans lequel le circuit intégré (100) électronique et une antenne (124) sont rapportés sur un support (130) pour l'interface de RF (122) sans contact avant l'exécution de la vérification de sorte que la réception de la commande de vérification (144) et l'envoi de la réponse de vérification (148) ont lieu par le biais de l'antenne (124), où un premier domaine de tolérance est employé en tant que domaine de tolérance.

12. Procédé selon la revendication 11, dans lequel, pour la vérification du circuit intégré (100) avant sa liaison avec l'antenne (124), le circuit intégré (100) est mis en contact avec des contacts de mesure et la réception de la commande de vérification (144), ainsi que l'envoi de la réponse de vérification (148), ont lieu par le biais des contacts de mesure, où, en tant que domaine de tolérance, on emploie un deuxième domaine de tolérance, différent du premier domaine de tolérance.

13. Procédé selon la revendication 11 ou 12, dans lequel le support (130) est conçu sous forme de couches et à partir du support (130), et de l'antenne (124) se trouvant au-dessus, et du circuit intégré (100), à la condition de la signalisation de l'existence de la vérification, et à partir d'autres couches de papier et/ou de matière plastique, un corps de document multicouche est formé pour la fabrication d'un document.

14. Procédé selon la revendication 13, dans lequel la vérification du circuit intégré (100) est de nouveau exécutée par la réalisation des étapes a) à e) après la fabrication du corps de document et après la réussite de cette vérification renouvelée, la personnalisation de la mémoire (114) électronique non volatile est exécutée, ce par quoi le circuit intégré (100) est mis de manière irréversible dans son deuxième état personnalisé.

15. Document doté d'un corps de document comprenant un circuit intégré (100), qui présente une interface de RF (122) sans contact, laquelle est reliée électriquement avec une antenne (124) du document, où le circuit intégré (100) présente une mémoire (114) électronique non volatile protégée et pouvant être personnalisée, et le circuit intégré a un premier état non personnalisé et un deuxième état personnalisé, où une transition du premier état vers le deuxième état n'est pas réversible, où l'interface de RF est conçue pour la réception de commandes de carte à puce et pour l'envoi de réponses à des commandes de cartes à puce, où une commande de vérification (144) fait partie de manière complémentaire des commande de carte à puce, et une réponse de vérification (148) fait partie des réponses suite à la commande de vérification, où le circuit intégré (100) est configuré de telle manière qu'une exécution de la commande de vérification et une réponse à la commande de vérification n'ont lieu avec la réponse de vérification que si le circuit intégré se trouve dans le premier état, où l'exécution de la commande de vérification provoque l'exécution d'une séquence prédéterminée d'opérations par le circuit intégré, où le circuit intégré présente une mémoire de programme (106) non volatile dans laquelle au moins des premières instructions de programme (110) et des deuxièmes instructions de programme (112) sont stockées, où le circuit intégré est configuré de telle manière qu'une fonction cryptographique, qui est mise en oeuvre par les deuxièmes instructions de programme, peut être activée par au moins une des commandes de carte à puce, afin de vérifier une condition d'accès pour un accès externe sur la mémoire électronique non volatile, où par les premières instructions de programme, l'exécution de la séquence prédéterminée d'opérations est mise en oeuvre par le circuit intégré, afin de simuler l'exécution de la fonction cryptographique par la mise en oeuvre nécessaire des deuxièmes instructions de programme afin de simuler l'exécution de la fonction cryptographique par les deuxièmes instructions de programme par le biais de l'interface de RF, où le circuit intégré est configuré de telle manière que l'exécution des premières instructions de programme ne peut avoir lieu par la commande de vérification que si le circuit intégré se trouve dans son premier état non personnalisé, et où le circuit intégré est configuré de telle manière que l'activation de la fonction cryptographique des deuxièmes instructions de programme n'est possible par la commande de carte à puce que si le circuit intégré se trouve dans son deuxième état personnalisé.

16. Document selon la revendication 15, dans lequel la fonction cryptographique contient la génération d'un défi, un cryptage ou un décryptage avec une clé symétrique ou asymétrique, un échange de clés de Diffie-Hellman et/ou une multiplication de points sur une courbe elliptique ou une combinaison de deux ou plusieurs de telles opérations cryptographiques.

17. Document selon la revendication 15 ou 16, dans lequel le circuit intégré est configuré de telle manière que, par l'exécution des premières instructions de programme, un volume de données prédéterminé est généré à partir de données pseudo-aléatoires et est stocké à l'état crypté dans une mémoire de travail du circuit intégré, où les paramètres cryptographiques nécessaires pour l'exécution des premières instructions de programme en vue du cryptage des données pseudo-aléatoires sont stockés à l'état inchangé dans une mémoire électronique non volatile du circuit intégré.

18. Document selon l'une des revendications précédentes 15 à 17, dans lequel un système consommateur (168, 170) fait partie du circuit intégré ou est associé au circuit intégré, dans lequel le circuit intégré est configuré de telle manière que le système consommateur est activé par l'exécution de la commande de vérification.

19. Document selon la revendication 18, dans lequel, dans le cas du système consommateur, il s'agit d'un dispositif d'affichage, en particulier, d'un dispositif d'affichage pour l'affichage de données d'image stockées au deuxième état personnalisé dans la mémoire électronique non volatile, et/ou d'un capteur, en particulier, un capteur biométrique pour la détection de données biométriques pour l'authentification d'un utilisateur vis-à-vis du circuit intégré, afin d'activer l'exécution d'une fonction de carte à puce, en particulier, de la fonction cryptographique, par le circuit intégré, où une tension de fonctionnement est appliquée au système consommateur par l'activation.

20. Document selon l'une des revendication précédentes 15 à 19, dans lequel il s'agit d'un document électronique de valeur ou d'un document de sécurité, en particulier, d'un document d'identité électronique, en particulier, un passeport, une carte d'identité, un visa, un permis de conduire, une immatriculation de véhicule, un titre de propriété de véhicule, une carte d'entreprise, une carte de santé ou d'un autre document d'identification, en particulier une carte à puce, un moyen de paiement, en particulier un billet de banque, une carte bancaire ou une carte de crédit, un connaissement, une carte d'entrée ou un autre carte d'autorisation.

21. Système de vérification doté d'un terminal (136) et d'un document selon l'une des revendications 15 à 20, où le système de vérification est configuré pour l'exécution d'un procédé selon l'une des revendications 1 à 10.

22. Système de personnalisation doté d'un système de vérification selon la revendication 21 et doté d'un dispositif de personnalisation (160) pour la personnalisation de la mémoire électronique non volatile du document, dans lequel le système de vérification est relié avec le dispositif de personnalisation de sorte que le signal (158) généré par le terminal pour la signalisation de l'existence de la vérification est transmis au dispositif de personnalisation, de sorte que le dispositif de personnalisation personnalise ensuite la mémoire électronique non volatile du document.
